# EUROPEAN PATENT APPLICATION

(11) **EP 3 671 822 A1**
(43) Date of publication of application: **24.06.2020**
(21) Application number: 18214583.9
(22) Date of filing: 20.12.2018
(51) Int. Cl.: H01L 21/768, H01L 21/033

(54) **SELF-ALIGNED CONTACT HOLE AND PILLAR ARRAY PATTERNING**

(71) Applicant: IMEC vzw, 3001 Leuven (BE)
(72) Inventor: LEE, Jae Uk, 3001 Leuven (BE)
(74) Representative: DenK iP

(57) **Abstract**

A method for hole patterning, comprising: providing (110) a stack; applying (120) a first line pattern (220) in a first direction on a hard mask (210) using self-aligned multiple patterning; depositing (130) a first layer (230) and etching back to obtain a flat surface; applying (140) a second line pattern (240) in a second direction, different from the first direction, over the first line pattern (220) and over the first layer (230) using self-aligned multiple patterning; depositing (150) a second layer (250) and etching back to obtain a flat surface; selectively removing (160) material of the first line pattern (220) and material of the second line pattern (240) thereby obtaining a hole pattern (260) at cross-sections of the first line pattern (220) and the second line pattern (240) towards the hard mask (210); transferring (170) the hole pattern (260) into the hard mask (210).

## Description

### Field of the invention

The invention relates to the field of forming patterns in a semiconductor device. More specifically it relates to a method of self-aligned contact hole and pillar array patterning.

### Background of the invention

As the size of the transistor continues to scale down beyond 193 nm lithography resolution, the need to engineer new alternatives which enable smaller critical dimensions (CD) arises.

In order to scale down the IC size beyond lithography resolution, self-aligned double patterning (SADP), self-aligned quadruple patterning (SAQP) or more in general self-aligned multiple patterning (SAMP) is presented by the semiconductor industry. These patterning techniques aim to pattern a one-dimensional line which has a width smaller than the lithographic resolution. In parallel, self-aligned contact or pillar printing is also proposed in the prior art.

However, all those techniques need an additional trim step to remove redundant patterning which is inevitable in these SAMP methods. A redundant pattern residue is for example inherently present at the line end. For this trim step an expensive high-resolution mask (trim or block) is required, to define the final target after self-aligned patterning. The additional trim (or block) mask has several challenges such as overlay, corner rounding, edge placement error and CD uniformity issue.

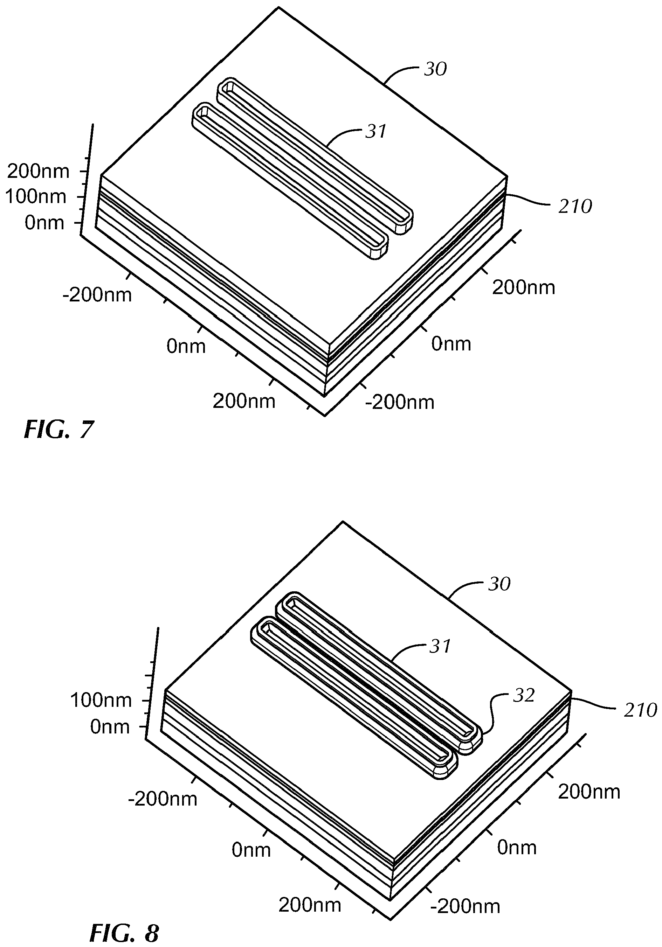

In order to form holes or pillars cross-SADP may be implemented. This is described by Shohei Yamauchi et al. in Proc. SPIE 8682, Advances in Resist Materials and Processing Technology XXX, 86821D (29 March 2013), "Extendibility of self-aligned type multiple patterning for further scaling". This paper discusses using dual tone development technology in combination with hole trimming to form a cut pattern, thereby alleviating the problem of overlay accuracy (see for example FIG. 8 of the paper).

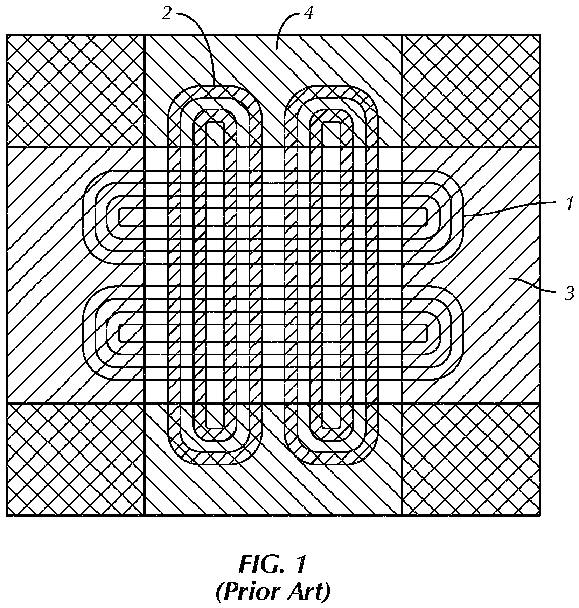

An example of a stack obtained after cross-SAQP is illustrated in FIG. 1. It shows a first line pattern 1 obtained after applying SAQP for a first time, and a second line pattern 2, orthogonal to the first line pattern, obtained after applying SAQP for a second time. Residues are present at the outer ends of the patterns as a result of the SAQP. The figure also shows a first trim mask 3 and a second trim mask 4 to remove these residues.

Using these techniques, it is possible to apply contact hole patterning having a resolution beyond the lithography resolution. When using EUV lithography a resolution with a pitch around 32nm, and a critical dimension around 16nm, can be obtained.

As discussed above an important problem to tackle are the residues which are inherently present as a result of the self-aligned multiple patterning. In the prior art these residues are removed by an additional trim step. However, this requires an expensive additional mask.

There is therefore a need for methods for forming patterns with smaller critical dimensions than the lithography resolution and which tackle the problem of the expensive additional high-resolution masks which are required for removing the residues.

### Summary of the invention

It is an object of embodiments of the present invention to provide a good method for forming an array of self-aligned holes or of self-aligned pillars.

The above objective is accomplished by a method and device according to the present invention.

Embodiments of the present invention relate to a method for hole patterning. The method comprises:
- providing a stack comprising a hard mask,
- applying a first line pattern in a first direction on the hard mask by using self-aligned multiple patterning,
- depositing a first layer and etching back to remove material of the first layer from the first line pattern to obtain a flat surface of the first layer, wherein the material of the first line pattern is selectively removable with respect to material of the first layer,
- applying a second line pattern in a second direction over the first line pattern and over the first layer by using self-aligned multiple patterning, wherein the second direction is different from the first direction,
- depositing a second layer and etching back to remove the material of the second layer from the second line pattern to obtain a flat surface of the second layer, wherein material of the second line pattern is selectively removable with respect to material of the second layer,
- selectively removing material of the first line pattern and material of the second line pattern thereby obtaining a hole pattern at cross-sections of the first line pattern and the second line pattern towards the hard mask,
- transferring the hole pattern into the hard mask.

It is an advantage of embodiments of the present invention that only the hole pattern is transferred in the hard mask. Thus, any residues which might be present in the first line pattern or in the second line pattern will not be transferred in the hard mask. Therefore, it is also not required to provide expensive additional high-resolution masks for removing residues.

In embodiments of the present invention applying the first line pattern and applying the second line pattern is done by self-aligned multiple patterning.

In embodiments of the present invention the first line pattern and the second line pattern may for example be applied by self-aligned double patterning, or self-aligned quadruple patterning.

It is an advantage of embodiments of the present invention that the redundant pattern residues which are inherently present at the line end of the patterns obtained by self-aligned multiple patterning are not transferred into the hard mask layers.

In embodiments of the present invention the material of the first layer is the same as the material of the second layer. In embodiments of the present invention the material of the first line pattern is the same as the material of the second line pattern.

In embodiments of the present invention the angle between the first direction and the second direction is ranging between 30 ° and 150°.

In embodiments of the present invention a pillar array is formed from the hole pattern in the hard mask.

In embodiments of the present invention contact holes are formed from the hole pattern in the hard mask.

In embodiments of the present invention the contact holes are formed as contact holes in a memory array.

It is an advantage of embodiments of the present invention that dense dynamic random-access memories can be obtained.

In embodiments of the present invention the contact holes are formed as contact holes in a 3-dimensional not-AND gate.

It is an advantage of embodiments of the present invention that dense dynamic NAND gates can be obtained.

In embodiments of the present invention the material of the first layer and the material of the second layer are oxides.

In embodiments of the present invention the material of the first line pattern and the material of the second line pattern are nitrides.

In embodiments of the present invention the hard mask comprises titanium nitride.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a schematic drawing of a prior art stack of two crossing line patterns which are obtained by two times self-aligned quadruple patterning; the drawing also shows 2 additional trim masks for removing residues which are present as a result of the self-aligned quadruple patterning.
FIG. 2 shows a flow chart of method steps of an exemplary method in accordance with embodiments of the present invention.
FIG. 3 shows a schematic drawing of a pattern stack obtained after a first core lithography step in accordance with embodiments of the present invention.
FIG. 4 shows a schematic drawing of the stack after transferring the patterned feature in amorphous carbide in accordance with embodiments of the present invention.
FIG. 5 shows a schematic drawing of the stack after a first spacer deposition in accordance with embodiments of the present invention.
FIG. 6 shows a schematic drawing of the stack after removal of the amorphous carbide.
FIG. 7 shows a schematic drawing of the stack after transferring the spacer into amorphous silicon in accordance with embodiments of the present invention.
FIG. 8 shows a schematic drawing of the stack after deposition of a second spacer in accordance with embodiments of the present invention.
FIG. 9 shows a schematic drawing of the stack after memorizing the obtained pattern in a silicon nitride layer in accordance with embodiments of the present invention.
FIG. 10 shows a schematic drawing of the stack after tone inversion (fill up background and etch back) in accordance with embodiments of the present invention.
FIG. 11 shows a schematic drawing of the stack after applying a second line pattern using self-aligned quadruple patterning and tone inversion in accordance with embodiments of the present invention.
FIG. 12 shows a schematic drawing of the stack after selective etching of the first- and second-line patterns; the figure shows the resulting hole pattern in accordance with embodiments of the present invention.
FIG. 13 shows a schematic drawing of the stack after transferring the hole pattern in the hard mask in accordance with embodiments of the present invention.
FIG. 14 shows a schematic drawing of a first line pattern and a second line pattern, wherein the angle between the first direction and the second direction is 60° or 120° in accordance with embodiments of the present invention.

Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where in embodiments of the present invention reference is made to "a direction" of a line pattern, reference is made to the direction of the lines of the line pattern.

Embodiments of the present invention relate to a method 100 for hole patterning. In methods according to embodiments of the present invention a first line pattern is applied in a first direction, after which it is inverted, a second line pattern is applied in a second direction different from the first direction, and also this pattern is inverted. The obtained crossing line patterns are selectively removed. Only at the cross-sections of the line patterns holes can be formed through both line patterns. These can be memorized into a hard layer. Thereby none of the residues of the first and second line pattern are transferred in the hard mask (only the openings made in the crossings of the patterns are transferred in the hard mask).

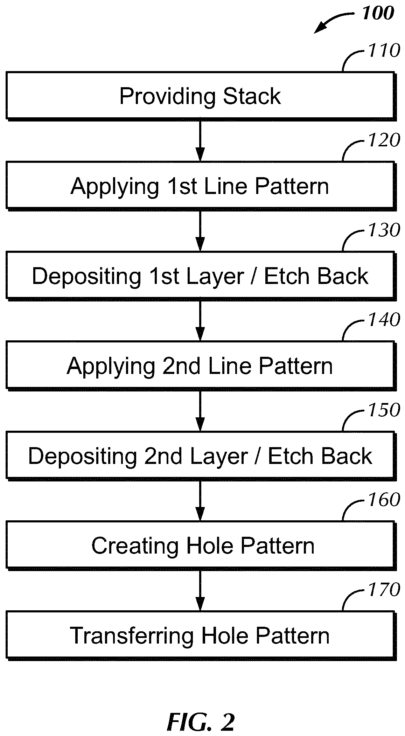

Method steps of a method in accordance with embodiments of the present invention are illustrated in the flow chart of FIG. 2. The method comprises:
- providing 110 a stack which comprises a hard mask 210,
- applying 120 a first line pattern 220 in a first direction on the hard mask 210 by using self-aligned multiple patterning,
- depositing 130 a first layer 230 and etching back to remove material of the first layer 230 from the first line pattern 220 to obtain a flat surface of the first layer 230, wherein the material of the first line pattern 220 is selectively removable (e.g. etchable) with respect to material of the first layer 230,
- applying 140 a second line pattern 240 in a second direction over the first line pattern 220 and over the first layer 230 by using self-aligned multiple patterning, wherein the second direction is different from the first direction,
- depositing 150 a second layer 250 and etching back to remove the material of the second layer 250 from the second line pattern 240 to obtain a flat surface of the second layer 250, wherein material of the second line pattern 240 is selectively removable (e.g. etchable) with respect to material of the second layer 250,
- selectively removing 160 material of the first line pattern 220 and material of the second line pattern 240 thereby obtaining a hole pattern 260 at cross-sections of the first line pattern 220 and the second line pattern 240 towards the hard mask 210,
- transferring the hole pattern 260 into the hard mask 210.

The steps of depositing 130 and etching back the first layer and of depositing 150 and etching back the second layer result in tone inversion. By tone inversion trenches are obtained instead of pillars. This allows to obtain small holes in the provided first and second line pattern at the cross-sections thereof, without having the need for an additional mask for removing residues which are present in a state of the art SAMP process. Although tone inversion comes with an increased cost, this cost is less than the cost of an additional high-resolution mask.

In embodiments of the present invention the first line pattern and the second line pattern are applied by cross integration of SAMP, SAQP, or SADP. Application of a pattern is followed by depositing of a layer and etch back of this layer. The materials are selected such that the pattern is selectively removable (e.g. etchable) with respect to the deposited layer. Thus, tone inversion can be achieved.

It is an advantage of embodiments of the present invention that they can print a pattern resolution than the lithography resolution. It is an advantage of a method in accordance with embodiments of the present invention that a pitch below 20nm can be obtained.

In an exemplary embodiment of the present invention horizontal argon fluoride immersion lithography (iArF) SAQP (or SAMP) followed by tone inversion, and vertical iArF SAQP (or SAMP) followed by tone inversion are combined. This combination makes it possible to pattern 10nm contact holes and pillars without the need for an additional mask for removing residues.

Methods according to embodiments of the present invention can be used in 3D NAND and DRAM structures. These structures require a dense contact hole array. It is cost effective because it doesn't need trim (or cut, block) mask to define line end and outside of self-aligned patterning region.

In the following figures intermediate stacks, obtained when applying different steps of a method in accordance with embodiments of the present invention, are schematically illustrated.

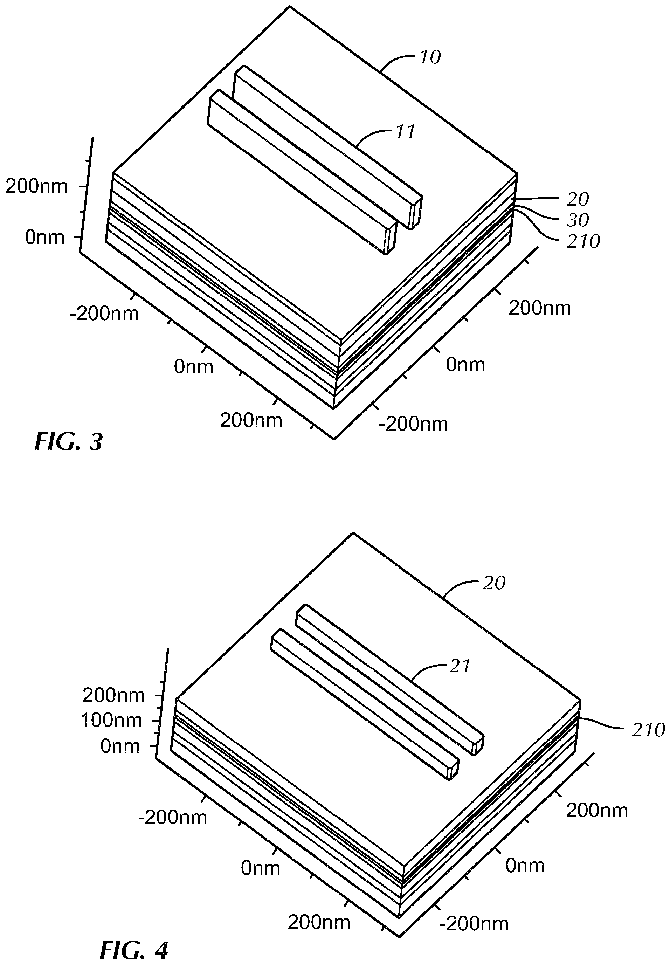

FIG. 3 shows a pattern stack which can be used for SAMP. In accordance with embodiments of the present invention a stack is provided 110 which comprises a hard mask 210. The stack shows the result after a first core lithography step. The stack shows a patterned feature 11 on a layer 10 obtained by photoresist patterning. In this example the patterned feature 11 comprises two parallel lines (also referred to as pillars). The invention is, however, not limited this line pattern. The number of mine patterns may be 1, 2 or more. The stack comprises a hard mask layer 210 on which a first line pattern 220 will be formed, starting from the patterned feature 11, by SAMP.

In the following figures is illustrated how a first line pattern 220, having a first direction, can be applied 120 on the hard mask 210. In FIG. 4 the patterned feature 11 is transferred into an underlying layer thereby obtaining a mandrel 21 on top of a layer 20. The mandrel 21 may for example comprise amorphous carbon (a-Ca). Another material can also be used as long as etch selectivity can be obtained with respect to a spacer 22 at the side walls of the mandrel 21. The spacer may for example comprise an oxide and the mandrel may be a carbide because a different etch selectivity can be obtained for the oxide and the carbide.

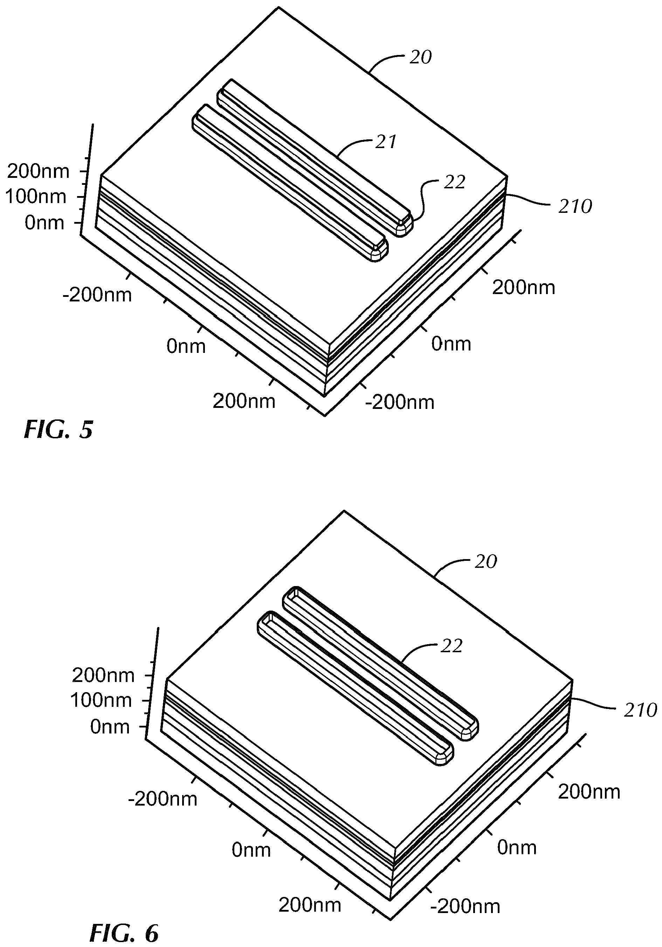

FIG. 5 schematically illustrates a stack obtained after a first spacer deposition and after removing the spacer at the top of each pillar 21 and at the bottom of the pit in between the pillars 21. After the first spacer deposition spacer material is present on top of the pillars 21. Between the pillars 21 a pit is present in the spacer material. It is this spacer material at the top of the pillar and at the bottom of the pit that is removed, thus leaving only spacer material at the side walls of the pillars. The material deposited in this step is typically silicon oxide. However, other materials such as silicon nitride can also be used, as long as etch selectivity with the material of the mandrel is possible. In embodiments of the present invention the spacer material may be deposited with atomic layer deposition. The partial spacer removal may be done by etching (e.g. chemical mechanical polishing). What remains is a mandrel 21 with spacer material 22 on the sides thereof, on top of an underlying layer 20.

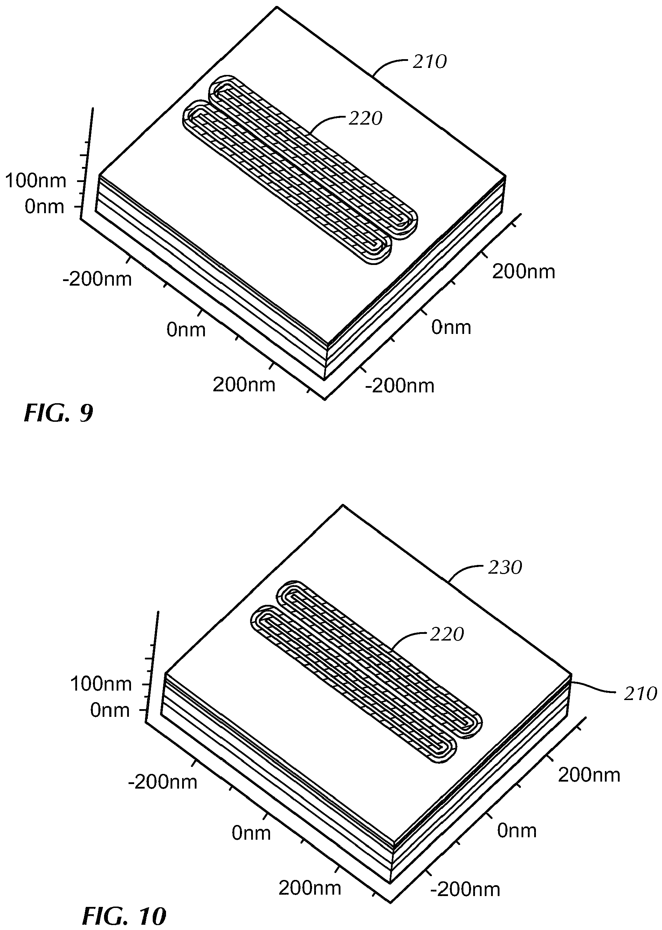

FIG. 6 shows a schematic drawing of a stack after removal of the mandrel 21. After removal of the mandrel the spacer 22 is remaining. As can be seen, double patterning is obtained compared to the configuration with the mandrels. As can be seen from this schematic drawing, at the outer ends, the line patterns of the spacer 22 are closed. This is inherently the case because of the double patterning. In prior art methods these residues are removed by a cut or trim step which requires an additional mask. In case of SAQP, the remaining spacer 22 is transferred in the layer 20 below, which is in this example an amorphous silicon layer. In case of SADP, tone inversion in accordance with embodiments of the present invention may be implemented as a next step (this will be explained when discussing FIG. 10).

After transferring the remaining spacer 22 in the layer 20, a stack, as schematically illustrated in FIG. 7 is obtained. The resulting pattern 31 is again a mandrel but in this case for the second spacer deposition. The mandrel 31 is present on a layer 30.

The stack obtained after depositing the second spacer (e.g. silicon oxide) and after etching is illustrated in FIG. 8. Also, in this case, a spacer 32 is present on the vertical sidewalls of the mandrels 31 (at the inner and the outer side of the mandrels), and a spacing is present between the adjacent spacers of adjacent mandrels and between the adjacent spacers inside a mandrel 31.

Next the mandrels 31 are removed, and the remaining spacers are transferred in the underlying layer 30, thus obtaining a first line pattern 220 on top of the hard mask layer 210. The resulting stack is shown in FIG. 9. The underlying layer 220 into which the remaining spacer is transferred may for example be a SiN layer. As can be seen in the figure the lines of the first line pattern 220 are closed at the outer ends. In prior art methods these residues are removed by a cut or trim step.

The steps explained above correspond with the steps of SAQP. Alternatively, SADP, or in general SAMP may be applied. An essential step in the present invention is the next step wherein tone inversion is enabled. This is achieved by depositing 130 a first layer 230 (e.g. silicon oxide) over the first line pattern 220, and by etching back (CMP) the deposited layer 230 to have 220 and 230 layer at the same level. The result thereof is shown in the stack of FIG. 10. The first line pattern 220 should be selectively removable (e.g. etchable) with respect to the first layer 230. Thus, tone inversion can be obtained.

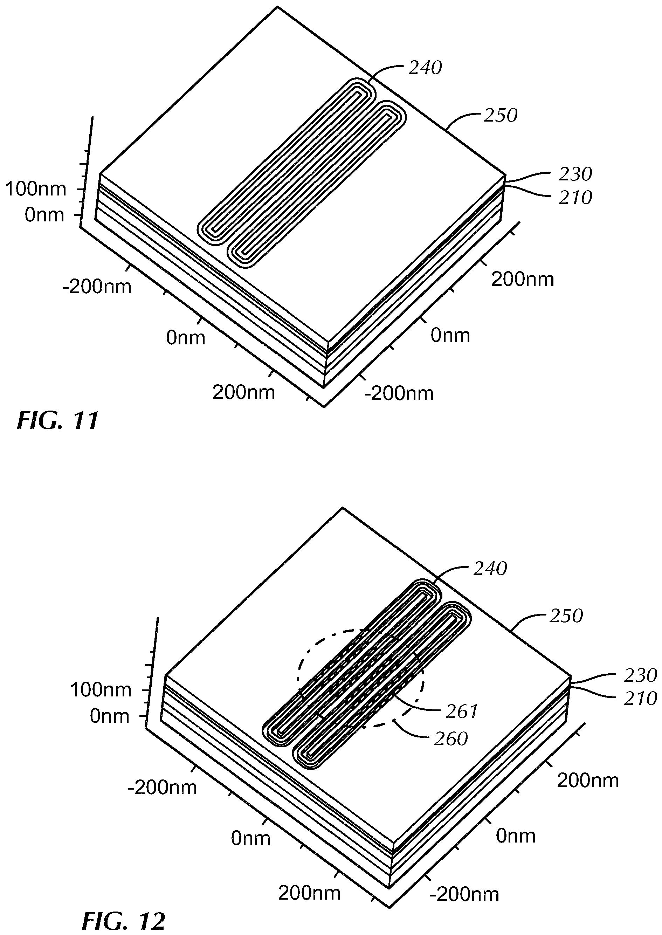

The sequence of steps explained above is executed for a second time, starting from the stack in FIG. 10, to apply 140 a second line pattern 240 in a second direction different from the first direction. Also, in this case SAQP, SADP, or in general SAMP may be applied. Also essential for the pattern in the second direction is that a tone inversion step is applied. This is enabled by depositing 150 a second layer 250 and etching back to remove the material of the second layer 250 which is present on top of the second line pattern 240 to obtain a flat surface of the second layer 250. The material of the second line pattern 240 is selectively removable (e.g. etchable) with respect to material of the second layer 250. The result thereof is shown in the stack of FIG. 11.

Because of the first layer 230 and the second layer 250, it is possible to selectively remove 160 the first- and second-line pattern (e.g. made of SiN material). Because of the crossed patterns, this will result in a hole pattern which can be transferred in a hard mask below the two patterned layers. Only the cross-sections of the first line pattern in the first direction with the second line pattern in the second direction can be transferred to the hard-mask. As a result thereof, no residues will be present in the hard mask. After etching, a stack as schematically shown in FIG. 12 is obtained. The figure shows a hole pattern 260, with holes 261.

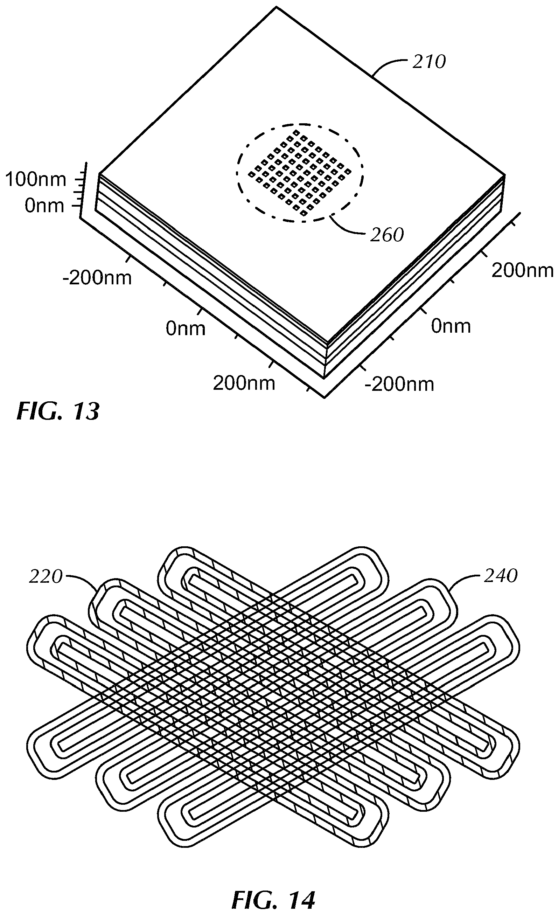

Underneath the first layer 230 a hard mask 210 is present in direct contact with the first layer 230. In a next step the hole pattern 260 is transferred 170 into the hard mask 210, and the first layer 230 and the second layer 250 are removed. The resulting stack is schematically drawn in FIG. 13. Thus, by tone inversion it is possible to only transfer the hole pattern which is relevant for the device. Hence, it is not required to implement a cut mask for removing residues which are present after state of the art SADP or SAQP.

In embodiments of the present invention the hard mask 210 may for example be a titanium nitride layer. The hard mask may thereby be selected such that it enables 1 of patterning where multi-patterning is applied. The hard mask may be selected such that it can memorize a pattern of a first process until the last patterning step. It enhances etch selectivity between the dielectric and the hard mask.

In embodiments of the present invention the first material may be the same as the second material.

In embodiments of the present invention the angle between the first direction and second direction is ranging between 30 ° and 130°. In embodiments of the present invention the angle between the first direction and the second direction may for example be around 90°, around 60°, or around 120°. An example of a first line pattern 220 and a second line pattern 240, wherein the angle between the first direction and the second direction is 60° or 120° is schematically illustrated in FIG. 14. As can be seen from this figure such a design may be used to obtain a hexagonal configuration.

A method 100 according to embodiments of the present invention may comprise a step obtaining a pillar array from the hole pattern 260 in the hard mask. Pillar formation may be implemented by depositing a metal before the SAMP process and by etching the metal except for the pillar shape, the etching step may be followed by filling of dielectric material.

A method 100 according to embodiments of the present invention may comprise a step for obtaining contact holes from the hole pattern 260 in the hard mask. A stack provided, using a method in accordance with embodiments of the present invention, may comprise from top to bottom: a photo-resist layer, a SiOC layer 10, an amorphous carbon layer, an amorphous silicon layer 20, a silicon nitride layer 30, a titanium nitride layer 210, an oxide layer, a silicon wafer. Starting from this stack a patterned feature 11 can be obtained in the photo resist. Thus, obtaining a stack as illustrated in FIG. 3. In the amorphous carbon layer, the mandrel 21 may be formed, thus obtaining a stack as illustrated in FIG. 4. On this stack similar steps as illustrated from FIGs 5 to 13 may be performed.

Alternative stacks may be provided. In another exemplary stack a silicon nitride layer may be present between the amorphous carbon layer of the previous stack and the amorphous silicon layer 20. In an exemplary stack the layer 270 directly below the hard mask 210 may be a metal layer (e.g. Co/W) instead of an oxide layer as in FIG. 15.

Other layers may be present between the hard mask 210 and the silicon wafer. In embodiments of the present invention contact holes may be obtained from the hole pattern in the hard mask. This may for example be achieved by a hard mask removal step (the hole pattern is still present in the layer which was below the hard mask layer), followed by a copper electroplating step, followed by a CMP process. Before the copper electroplating step, a 1 nm Mn layer may be deposited, and a 1 nm Ru liner may be deposited, after which a copper seed layer may be deposited. The copper electroplating may be starting from this seed layer.

These contact holes may for example be used as holes in a memory array, for example in a dynamic random-access memory array (DRAM). This is particularly advantageous because dense and small areas for pillars or holes are required in memory arrays.

In other embodiments of the present invention the contact holes may be used as contact holes in a 3-dimensional NAND-gate.

## Claims

1. A method (100) for hole patterning, the method comprising:
- providing (110) a stack comprising a hard mask (210),
- applying (120) a first line pattern (220) in a first direction on the hard mask (210) by using self-aligned multiple patterning,
- depositing (130) a first layer (230) and etching back to remove material of the first layer (230) from the first line pattern (220) to obtain a flat surface of the first layer (230), wherein the material of the first line pattern (220) is selectively removable with respect to material of the first layer (230),
- applying (140) a second line pattern (240) in a second direction over the first line pattern (220) and over the first layer (230) by using self-aligned multiple patterning, wherein the second direction is different from the first direction,
- depositing (150) a second layer (250) and etching back to remove the material of the second layer (250) from the second line pattern (240) to obtain a flat surface of the second layer (250), wherein material of the second line pattern (240) is selectively removable with respect to material of the second layer (250),
- selectively removing (160) material of the first line pattern (220) and material of the second line pattern (240) thereby obtaining a hole pattern (260) at cross-sections of the first line pattern (220) and the second line pattern (240) towards the hard mask (210),
- transferring (170) the hole pattern (260) into the hard mask (210).

2. A method (100) according to claim 1 wherein applying (120) the first line pattern and applying (140) the second line pattern is done by self-aligned multiple patterning.

3. A method (100) according to any of the previous claims, wherein for applying (120, 140) the first line pattern (220) and the second line pattern (240) and for depositing (130, 150) the first layer (230) and the second layer (250), the same material is selected for the first layer and for the second layer and the same material is selected for the first line pattern and for the second line pattern.

4. A method according to any of the previous claims wherein the angle between the first direction and the second direction is ranging between 30 ° and 150°.

5. A method (100) according to any of the previous claims, the method comprising forming a pillar array from the hole pattern (260) in the hard mask (210).

6. A method (100) according to any of the claims 1 to 4, the method comprising forming contact holes from the hole pattern (260) in the hard mask (210).

7. A method according to claim 6, wherein the contact holes are formed as contact holes in a memory array.

8. A method (100) according to claim 6, wherein the contact holes are formed as contact holes in a 3-dimensional not-AND gate.

9. A method (100) according to any of the previous claims wherein the material of the first layer (230) and the material of the second layer (250) are oxides.

10. A method (100) according to any of the present invention wherein the material of the first line pattern (220) and the material of the second line pattern (240) are nitrides.

11. A method (100) according to any of the previous claims wherein the hard mask (210) comprises titanium nitride.
